# EUROPEAN PATENT APPLICATION

(11) **EP 4 749 857 A1**
(43) Date of publication of application: **27.05.2026**
(21) Application number: 25215097.4
(22) Date of filing: 11.11.2025
(51) Int. Cl.: H02H 3/08, H02H 3/02, H02H 3/10, H02H 9/04, H03K 17/16, H02H 3/05

(54) **LEAKAGE CURRENT MITIGATOR**

(30) Priority: 25.11.2024 US 202418958275
(71) Applicant: Schneider Electric USA, Inc., Andover, MA 01810 (US)
(72) Inventor: Shea, John J., Wake Forest, NC (US); Liptak, Julius Michael, Knightdale, NC (US)
(74) Representative: Manitz Finsterwald Patent- und Rechtsanwaltspartnerschaft mbB

(57) **Abstract**

An electrical protective device for an electrical circuit is configured to mitigate leakage current by directing leakage current away from a load connected to the electrical circuit, when the device enters a standby operating mode wherein the device operates at a reduced capacity. The device comprises at least one of a shunt switch, a crowbar circuit, and a common mode voltage protection system. The shunt switch provides a low resistance path for directing leakage current from a positive leg of the circuit connected to a line side of the device away from the load, and into a negative leg of the circuit connected to the line side. The crowbar circuit is used in addition to the shunt switch to mitigate fault conditions that could damage the shunt switch. The common mode voltage protection system is configured to provide a low resistance path for maintaining the load voltage near ground potential.

## Description

### FIELD

The present disclosure generally relates to an electrical protective device for mitigating leakage current in an electrical circuit.

### BACKGROUND

Leakage current is commonly defined as the current that flows in an unintended path through an electrical circuit into ground. For instance, when the electrical circuit does not include proper grounding connections, leakage current flows through the electrical circuit to any available conductive path. If a person contacts a component of the electrical circuit (e.g., a wire), the contact can provide a conductive path for the leakage current to flow to ground, thereby presenting a shock hazard to the person.

### SUMMARY

Aspects of the present disclosure permit an electrical protective device for mitigating leakage current in an electrical circuit when the electrical protective device enters a standby operating mode.

In one aspect, an electrical protective device configured to mitigate leakage current in an electrical circuit comprises a positive side electrical power control electrically connected to a line side of the electrical circuit and configured to control electrical power from a power source electrically connected to the electrical circuit. The positive side electrical power control is electrically connected in series with a load connected to the electrical circuit. A shunt switch is electrically connected to the electrical circuit between the positive side electrical power control and the load. The shunt switch is electrically connected in parallel with the load. The shunt switch is configured to provide a low resistance path for directing leakage current from the positive side electrical power control away from the load when the electrical protective device enters a standby mode wherein the positive side electrical power control is at least partially turned off.

In another aspect, an electrical protective device configured to mitigate leakage current in an electrical circuit comprises a positive side electrical power control electrically connected to a line side of the electrical circuit and configured to control electrical power from a power source electrically connected to the electrical circuit. The positive side electrical power control is electrically connected in series with a load connected to the electrical circuit. A crowbar circuit is electrically connected to the electrical circuit in series with the positive side electrical power control and in parallel with the load. The crowbar circuit is configured to provide a low resistance path for directing leakage current from the positive side electrical power control away from the load when the electrical protective device enters a standby mode wherein the positive side electrical power control is at least partially turned off.

In yet another aspect, an electrical protective device configured to mitigate leakage current in an electrical circuit comprises a positive side electrical power control system electrically connected to a line side of the electrical circuit and configured to control electrical power from a power source electrically connected to the electrical circuit. The positive side electrical power control is electrically connected in series with a load connected to the electrical circuit. A negative side electrical power control is electrically connected to a load side of the electrical circuit and configured to control electrical power from the power source electrically connected to the electrical circuit. The negative side electrical power control is electrically connected in series with the load. A common mode voltage protection system is electrically connected to the electrical circuit between the positive side electrical power control and the negative side electrical power control and in parallel with the load. The common mode voltage protection system is configured to provide a low resistance path for directing leakage current from at least one of the positive side electrical power control and negative side electrical power control, away from the load when the electrical protective device enters a standby mode wherein the load side and positive side electrical power controls are at least partially turned off.

Other objects and features will be in part apparent and in part pointed out hereinafter.

### BRIEF DESCRIPTION OF THE DRAWINGS

FIG. 1 is a schematic block diagram of an electrical protective device of the prior art.
FIG. 2 is a schematic block diagram of an electrical protective device comprising a mechanical shunt switch, according to an embodiment.
FIG. 3 is a schematic block diagram of an electrical protective device comprising an electronic shunt switch, according to an embodiment.
FIG. 4 is a schematic block diagram of the electrical protective device of FIG. 2, further comprising a crowbar circuit, according to an embodiment.
FIG. 5 is a schematic block diagram of the electrical protective device of FIG. 3, further comprising a crowbar circuit, according to an embodiment.
FIG. 6 is a schematic block diagram of an electrical protective device comprising a common mode voltage protection system, according to an embodiment.
FIG. 7 is a schematic block diagram of an electrical protective device comprising another common mode voltage protection system, according to an embodiment.
FIG. 8 is a schematic block diagram of a three-phase implementation of an electrical protective device, according to an embodiment.
FIG. 9 is a schematic block diagram of another three-phase implementation of an electrical protective device, according to an embodiment.

Corresponding reference characters indicate corresponding parts throughout the drawings.

### DETAILED DESCRIPTION

Electrical protective devices such as circuit breakers (e.g., solid state circuit breakers SSCB and hybrid circuit breakers HCB) are commonly used to protect electrical circuits from damages and fires caused by short circuits and overload conditions. Generally, these devices include various operating modes such as an on operating mode, an off operating mode, and a standby operating mode. One issue identified with conventional electrical protective devices is the presence of leakage current, also referred to as standby current, in the electrical circuit when the device is in the standby operating mode. In the standby operating mode, electrical protective devices are configured to operate in a high impedance state.

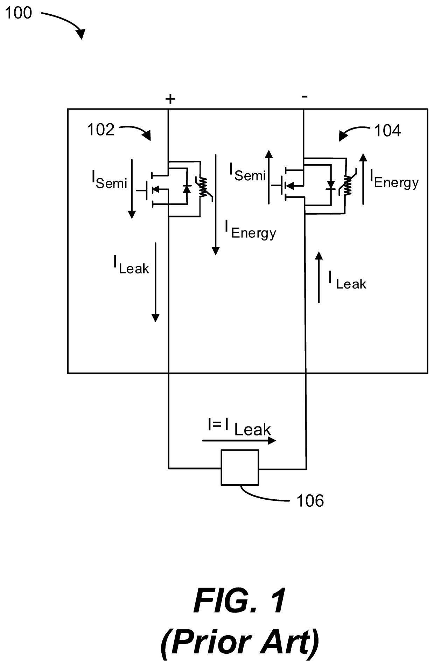

FIG. 1 provides an example of a conventional two-pole direct current electrical protective device 100 operating in standby mode. The conventional electrical protective device 100 includes a positive side electrical power control 102 and a negative side electrical power control 104 each being electrically connected in series with a load 106 connected to the electrical circuit. Particularly, when the conventional electrical protective device 100 (e.g., a DC SSCB) enters the standby operating mode, power controls 102, 104 are off but a leakage current I_{Leak} can flow through the positive side electrical power control 102 or the negative side electrical power control 104 and to the load 106, thus creating a potential electrical hazard (shock and fire) due to the load remaining energized. In another example, loads (e.g., loads with capacitance) may charge overtime while the electrical protective device 100 is in the standby operating mode and further present shock and fire hazards. Accordingly, the present disclosure provides an electrical protective device that is configured to mitigate leakage current in an electrical circuit when the electrical protective device enters a standby operating mode, thereby at least one of reducing and preventing electrical hazards caused by the leakage current.

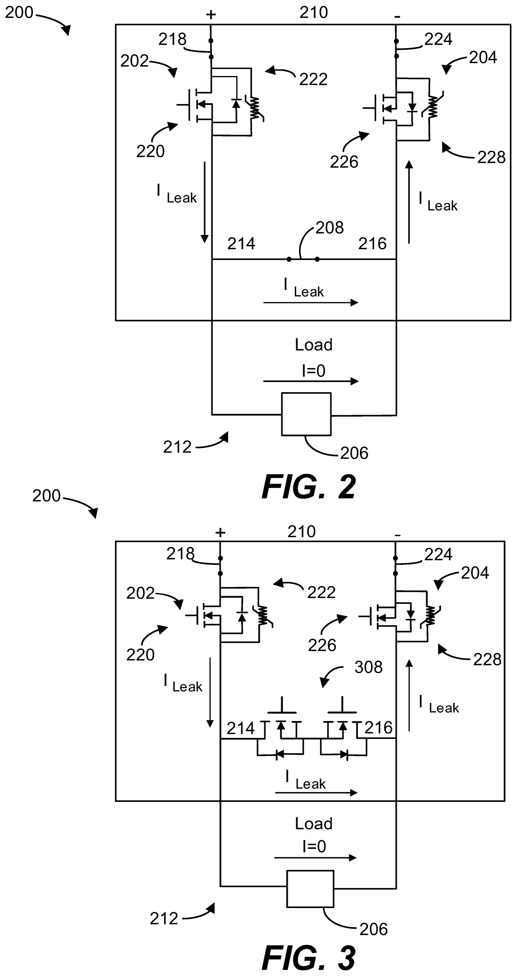

Referring now to FIG. 2, an exemplary embodiment of an electrical protective device in accordance with the present disclosure is generally indicated at reference number 200. In general, the electrical protective device 200 is configured to direct leakage current away from a load when the electrical protective device enters a standby operating mode. The electrical protective device 200 comprises a positive side electrical power control 202, a negative side electrical power control 204, and a shunt switch 208. The positive side electrical power control 202 is electrically connected to a positive terminal on the line side 210 of the electrical circuit, and the negative side electrical power control 204 is electrically connected to a negative terminal on the line side of the electrical circuit. Each of the positive side electrical power control 202 and negative side electrical power control 204 are connected in series with a load 206 connected to the electrical circuit on a load side 212 of the electrical circuit, and configured to control electrical power within the electrical circuit. The shunt switch 208 includes a first end 214 that is electrically connected to the electrical circuit between the positive side electrical power control 202 and the load 206, and a second end 216 that is electrically connected to the electrical circuit between the negative side electrical power control 204 and the load 206. The shunt switch 208 is configured to provide a low resistance path for directing leakage current I_{Leak} from the positive side electrical power control 202 bypassing the load 206 and into the negative side electrical power control 204 and vice versa when the electrical protective device 200 enters a standby mode.

In an exemplary embodiment, the positive side electrical power control 202 comprises an isolation switch 218, a semiconductor device 220, and an energy-absorbing clamp circuit 222. Similarly, the negative side electrical power control 204 comprises an isolation switch 224, a semiconductor device 226, and an energy-absorbing clamp circuit 228. However, it will be apparent to a person of ordinary skill in the art, that the positive side electrical power control 202 and negative side electrical power control 204 may include other electrical components known for controlling electrical power within an electrical circuit, without departing from the scope of the present disclosure. In the illustrated embodiments, current flows from the line side 210 (e.g., via a power source electrically connected to the line side power control 202) and into the negative side electrical power control 204. Accordingly, the negative side electrical power control 204 is configured to receive and mitigate leakage current I_{Leak} from the positive side electrical power control 202 via the path provided by the shunt switch 208, as will be discussed in further detail below. However, it is contemplated that the electrical protective device 200 may be configured to operate in a reverse manner wherein the current flows from the line side 210 (e.g., via a power source electrically connected to the negative side power control 204) and into the positive side electrical power control 202, and the positive side electrical power control is configured to receive and mitigate leakage current I_{Leak} from the negative side electrical power control 204 via the path provided by the shunt switch 208.

The isolation switch 218 and isolation switch 224 are each connected in series to a power source connected to the electrical circuit (not shown), and configured to isolate the electrical circuit from the power source. The isolation switches 218 and 224 are ganged together and thereby operate together. For example, when the isolation switches 218, 224 are opened, power from the power source is prevented from entering the electrical circuit (e.g., when the electrical protective device 200 is off). When the isolation switches 218, 224 are closed, power from the power source may enter the electrical circuit (e.g., when the electrical protective device 200 is on or enters standby mode).

The semiconductor device 220 is electrically connected in series with the isolation switch 218, and similarly the semiconductor device 226 is connected in series with the isolation switch 224. The semiconductor devices 220, 226 are generally configured to control current flow in the electrical circuit. The semiconductor devices 220, and 226 are also configured to operate in conjunction with one another. In one example, the semiconductor devices 220, 226 comprise metal-oxide semiconductor field effect transistors (MOSFETS). However, it will be apparent that other types of semiconductor devices may be used without departing from the scope of the present disclosure. When the electrical protective device 200 enters the standby mode, the semiconductor devices 220, 226 are turned off.

The energy-absorbing clamp circuit 222 is electrically connected in parallel with the semiconductor device 220, and the energy absorbing clamp circuit 228 is electrically connected in parallel with the semiconductor device 226. The energy-absorbing clamp circuits 222, 228 are configured to absorb energy in the electrical circuit. The semiconductor device 220 and energy absorbing clamp circuit 222 are electrically connected in series with the first end 214 of the shunt switch 208, and the semiconductor device 226 and energy-absorbing clamp circuit 228 are electrically connected in series with the second end 216 of the shunt switch 208.

The shunt switch 208 is electrically connected in parallel with the load 206. In general, the shunt switch 208 is configured to provide the low resistance path for directing leakage current I_{Leak} away from the load 206 when the electrical protective device 200 enters the standby mode. Particularly, when the electrical protective device 200 enters the standby mode, the shunt switch 208 closes to direct leakage current I_{Leak} from the positive side electrical power control 202 away from the load 206 and into the negative side electrical power control 204 and vice versa (when the electrical protective device 200 operates in the reverse manner). In FIG. 2, the shunt switch 208 is shown as a mechanical shunt switch, whereas in FIG. 3, the shunt switch is shown as an electronic shunt switch 308. When the electrical protective device 200 enters the on mode, the shunt switch 208, 308 is configured to turn off (e.g., open), and subsequently the positive side electrical power control 202 and/or the negative side electrical power control 204 is configured to turn fully on (e.g., the isolation switch 218, 224, the semiconductor device 220, 226, are on).

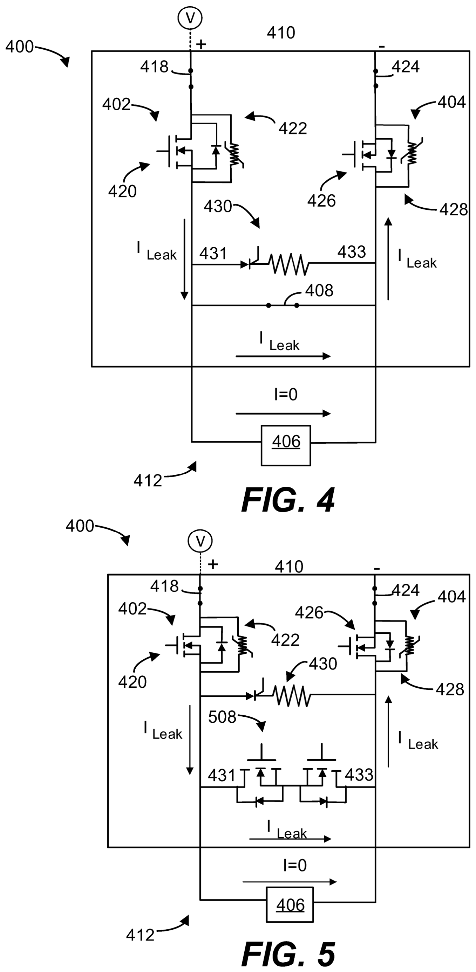

Referring to FIGS. 4-5, another embodiment of an electrical protective device in accordance with the present disclosure is generally indicated at reference number 400. The electrical protective device 400 has some similarities to the electrical protective device 200 described above and shown in FIGS. 2-3. For example, in the illustrated embodiment, the electrical protective device 400 includes the positive side electrical power control 402, the negative side electrical power control 404, and the shunt switch 408 (mechanical shunt switch), 508 (electronic shunt switch). However, the electrical protective device 400 includes a crowbar circuit 430 that is configured to provide a low resistance path for directing leakage current I_{Leak} from in the electrical circuit away from the load 406. In the illustrated embodiments, the crowbar circuit 430 is used in addition to the shunt switch 408, 508 to mitigate fault conditions (e.g., short circuit conditions) that could damage the shunt switch 408, 508. However, it is contemplated that in certain situations it may be applicable to use the crowbar circuit 430 alone for mitigating leakage current I_{Leak}. It is also contemplated that the electrical protective device 400 may be configured to operate in the reverse manner similar to the electrical protective device 200.

The crowbar circuit 430 comprises a first end 431 that is electrically connected to the electrical circuit between the positive side electrical power control 402 and the shunt switch 408, 508, and a second end 433 that is electrically connected to the electrical circuit between the negative side electrical power control 404 and the shunt switch. Accordingly, the crowbar circuit 430 is electrically connected in series with the positive side electrical power control 402 and negative side electrical power control 404, and in parallel with the shunt switch 408, 508 and load 406. In general, the crowbar circuit 430 is configured to provide a low resistance path for directing leakage current I_{Leak} from the positive side electrical power control 402 away from the load 406 and into the negative side electrical power control 404 and vice versa when the electrical protective 400 device enters the standby mode. At least one of the crowbar circuit 430 and shunt switch 408,508 are configured to turn off when the electrical protective device 400 enters an on mode, and subsequently the positive side electrical power control 402 and/or the negative side electrical power control 404 is configured to turn on (e.g., the isolation switch 418, 424, the semiconductor device 420, 426, are on).

In one embodiment, the electrical protective device 400 includes a voltage sensor V electrically connected to the electrical circuit. The voltage sensor V is configured to measure voltage on the line side 410 and load side 412 of the electrical circuit to determine when to use at least one of the crowbar circuit 430 and the shunt switch 408, 508 to direct leakage current from the positive side electrical power control 402 away from the load 406. For example, the crowbar circuit 430 is turned off, and the shunt switch 408, 508 is turned on when the voltage measured by the voltage sensor is below a predetermined threshold. The crowbar circuit 430 is turned on and the shunt switch 408, 508 is turned on when the voltage measured by the voltage sensor V meets or exceeds a predetermined threshold. Moreover, the voltage sensor V is configured to measure a first voltage of the electrical circuit before the crowbar circuit 430 is used and configured to measure a second voltage of the electrical circuit after the crowbar circuit is used to enable the electrical protective device 400 to use the shunt switch 408, 508 if the second voltage meets or exceeds a predetermined threshold.

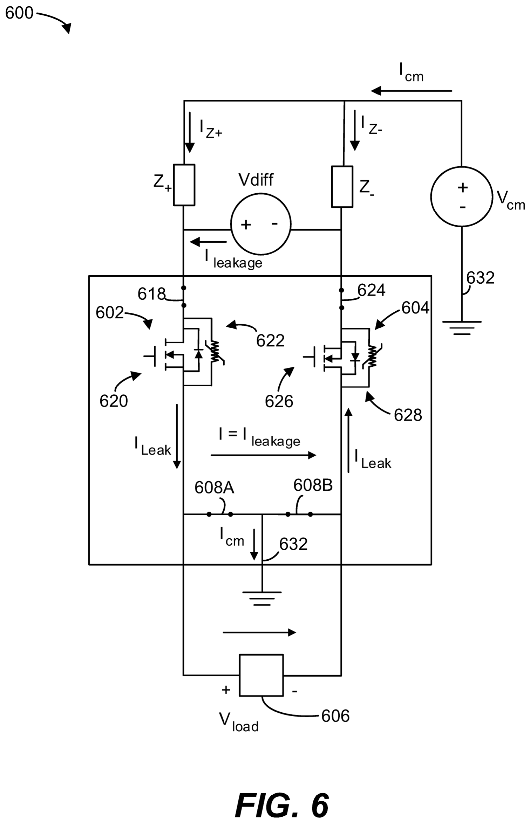

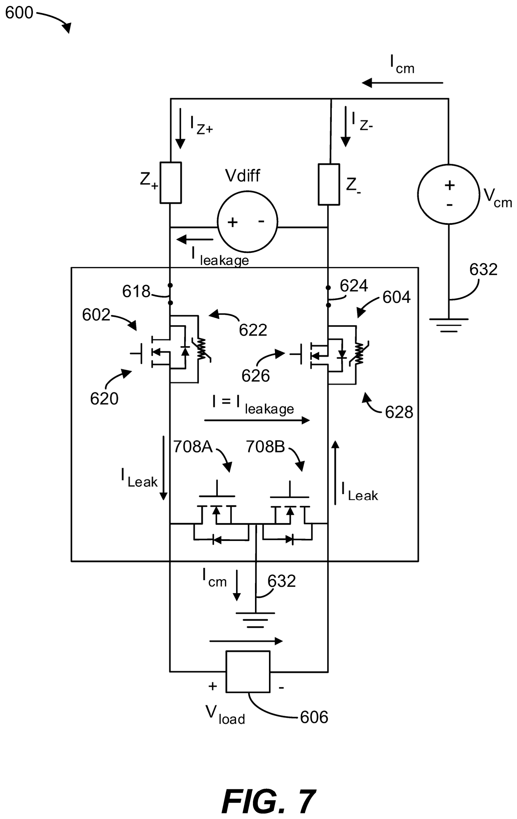

Referring to FIGS. 6-7, another embodiment of an electrical protective device in accordance with the present disclosure is generally indicated at reference number 600. The electrical protective device 600 has some similarities to the electrical protective device 200 described above and shown in FIGS. 2-3. For example, in the illustrated embodiment, the electrical protective device 600 includes the positive side electrical power control 602 and the negative side electrical power control 604. However, the electrical protective device 600 includes a common mode voltage protection system that is configured to provide a low resistance path for directing leakage current I_{Leak} from at least one of the positive side electrical power control 602 and negative side electrical power control 604, away from the load 606 when the electrical protective device 600 enters a standby mode wherein the load side and positive side electrical power controls are at least partially turned off.

In general, the electrical protective device 600 is configured to accommodate common mode voltage instances wherein leakage current I_{Leak} is present when the electrical protective device enters the standby mode. For example, in some instances there may be an unequal impedance in each leg of the electrical circuit that is connected to a voltage common to both sides of the differential source Vdiff.

The common mode voltage protection system is electrically connected to the electrical circuit between the positive side electrical power control 602 and the negative side electrical power control 604, and in parallel with the load 606. In an exemplary embodiment, the common mode voltage protection system comprises a first shunt switch 608A (first mechanical shunt switch), 708A (first electronic shunt switch), a second shunt switch 608B (second mechanical shunt switch), 708B (second electronic shunt switch), and a ground 632. The first shunt switch 608A, 708A is electrically connected in series between the positive side electrical power control 602 and the ground 632. The second shunt switch 608B, 708B are electrically connected in series between the negative side electrical power control 604 and the ground 632. Accordingly, the first shunt switch 608A, 708A directs leakage current I_{Leak} from the positive side electrical power control 602 into the ground 632 when the electrical protective device 600 enters the standby mode. Similarly, the second shunt switch 608B, 708B directs leakage current I_{Leak} from the negative side electrical power control 604 into the ground 632. This maintains the load common mode potential at ground potential to mitigate an additional potential electrical shock hazard.

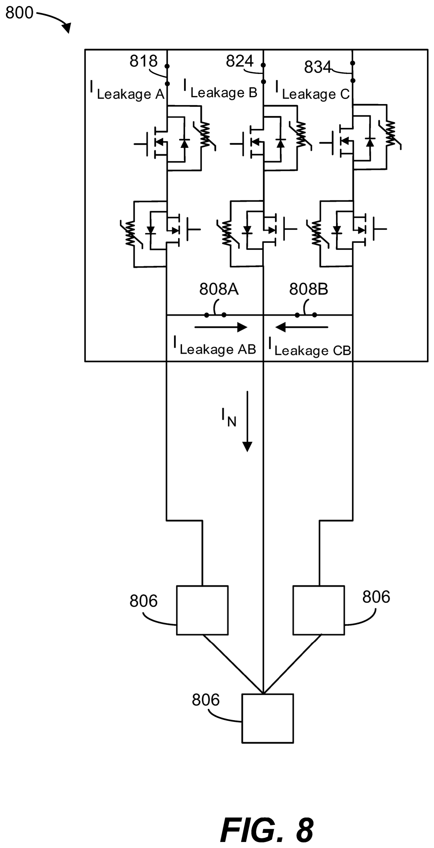

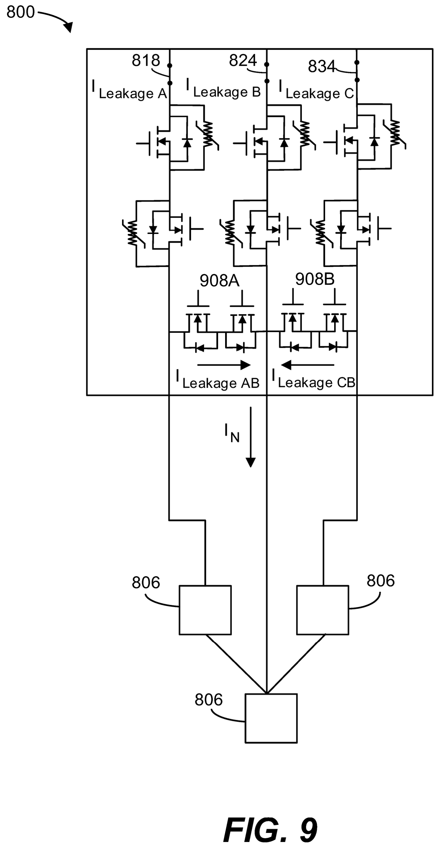

Referring now to FIGS. 8 and 9, another embodiment of an electrical protective device in accordance with the present disclosure is generally indicated at reference number 800. The electrical protective device 800 has some similarities to the electrical protective device 200 described above and shown in FIGS. 2-3. However, the electrical protective device 800 provides a three-phase implementation of the electrical protective device 200, In the illustrated embodiment, the electrical protective device 800 comprises an AC SSCB including a first shunt switch 808A (first mechanical shunt switch), 908A (first electronic shunt switch) and a second shunt switch 808B (second mechanical shunt switch), 908B (second electronic shunt switch). Each of the first and second shunt switches 808A, 908A, 808B, 908B are configured to provide a low resistance path for directing leakage current away from the loads 806 when the electrical protective device 800 enters a standby mode.

Embodiments of the present disclosure comprise a special purpose computer including a variety of computer hardware, as described in greater detail herein and are operational with other special purpose computing system environments or configurations even if described in connection with an example computing system environment. The computing system environment is not intended to suggest any limitation as to the scope of use or functionality of any aspect of the invention. Moreover, the computing system environment should not be interpreted as having any dependency or requirement relating to any one or combination of components illustrated in the example operating environment. Examples of computing systems, environments, and/or configurations that may be suitable for use with aspects of the present disclosure include, but are not limited to, personal computers, server computers, hand-held or laptop devices, multiprocessor systems, microprocessor-based systems, set top boxes, programmable consumer electronics, mobile telephones, network PCs, minicomputers, mainframe computers, distributed computing environments that include any of the above systems or devices, and the like.

Aspects of the present disclosure may be described in the general context of data and/or processor-executable instructions, such as program modules, stored one or more tangible, non-transitory storage media and executed by one or more processors or other devices. Generally, program modules include, but are not limited to, routines, programs, objects, components, and data structures that perform particular tasks or implement particular abstract data types. Aspects of the present disclosure may also be practiced in distributed computing environments where tasks are performed by remote processing devices that are linked through a communications network. In a distributed computing environment, program modules may be located in both local and remote storage media including memory storage devices. For purposes of illustration, programs and other executable program components may be shown as discrete blocks. It is recognized, however, that such programs and components reside at various times in different storage components of a computing device, and are executed by a data processor(s) of the device.

In operation, processors, computers, and/or servers may execute the processor-executable instructions (e.g., software, firmware, and/or hardware) such as those illustrated herein to implement aspects of the invention. The processor-executable instructions may be organized into one or more processor-executable components or modules on a tangible processor readable storage medium. Also, embodiments may be implemented with any number and organization of such components or modules. For example, aspects of the present disclosure are not limited to the specific processor-executable instructions or the specific components or modules illustrated in the figures and described herein. Other embodiments may include different processor-executable instructions or components having more or less functionality than illustrated and described herein.

The order of execution or performance of the operations in accordance with aspects of the present disclosure illustrated and described herein is not essential, unless otherwise specified. That is, the operations may be performed in any order, unless otherwise specified, and embodiments may include additional or fewer operations than those disclosed herein. For example, it is contemplated that executing or performing a particular operation before, contemporaneously with, or after another operation is within the scope of the present disclosure.

Not all of the depicted components illustrated or described may be required. In addition, some implementations and embodiments may include additional components. Variations in the arrangement and type of the components may be made without departing from the spirit or scope of the claims as set forth herein. Additional, different or fewer components may be provided and components may be combined. Alternatively, or in addition, a component may be implemented by several components.

Having described the invention in detail, it will be apparent that modifications and variations are possible without departing from the scope of the invention defined in the appended claims.

When introducing elements of the present invention or the preferred embodiments(s) thereof, the articles "a", "an", "the" and "said" are intended to mean that there are one or more of the elements. The terms "comprising", "including" and "having" are intended to be inclusive and mean that there may be additional elements other than the listed elements.

In view of the above, it will be seen that the several objects of the invention are achieved and other advantageous results attained.

As various changes could be made in the above products without departing from the scope of the invention, it is intended that all matter contained in the above description and shown in the accompanying drawings shall be interpreted as illustrative and not in a limiting sense.

The Abstract and Summary are provided to help the reader quickly ascertain the nature of the technical disclosure. They are submitted with the understanding that they will not be used to interpret or limit the scope or meaning of the claims. The Summary is provided to introduce a selection of concepts in simplified form that are further described in the Detailed Description. The Summary is not intended to identify key features or essential features of the claimed subject matter, nor is it intended to be used as an aid in determining the claimed subject matter.

## Claims

1. An electrical protective device configured to mitigate leakage current in an electrical circuit, the electrical protective device comprising:
a positive side electrical power control electrically connected to a positive terminal of a line side of the electrical circuit and configured to control electrical power from a power source electrically connected to the electrical circuit, wherein the positive side electrical power control is electrically connected in series with a load electrically connected to the electrical circuit; and
a shunt switch electrically connected to the electrical circuit between the positive side electrical power control and the load, the shunt switch electrically connected in parallel with the load, the shunt switch configured to provide a shunt low resistance path for directing leakage current from the positive side electrical power control away from the load when the electrical protective device enters a standby mode in which the positive side electrical power control is at least partially turned off.

2. The electrical protective device of claim 1, wherein the positive side electrical power control comprises an isolation switch, a semiconductor device, and an energy absorbing clamp circuit, the isolation switch configured to isolate the electronic circuit from the power source, the semiconductor device configured to control current flow in the electrical circuit, and the energy absorbing clamp circuit configured to absorb current in the electrical circuit.

3. The electrical protective device of claim 1 or 2, wherein in the standby mode, the semiconductor device is turned off, and/or
wherein the semiconductor device comprises a metal-oxide semiconductor field effect transistor.

4. The electrical protective of any one of the preceding claims, further comprising a negative side electrical power control electrically connected to a negative terminal on the line side of the electrical circuit, wherein a first end of the shunt switch is electrically connected to the electrical circuit between the positive side electrical power control and the load and a second end of the shunt switch is electrically connected to the electrical circuit between the negative side electrical power control and the load, and wherein the shunt switch is configured to provide the shunt low resistance path for directing leakage current from the positive side electrical power control away from the load and into the negative side electrical power control and vice versa.

5. The electrical protective device of any one of the preceding claims, wherein the shunt switch is configured to turn off when the electrical protective device enters an on mode,
wherein the positive side electrical power control is in particular configured to turn on after the shunt switch is turned off when the electrical power device enters the on mode.

6. The electrical protective device of any one of the preceding claims, further comprising a crowbar circuit electrically connected to the electrical circuit in series with the positive side electrical power control and in parallel with the shunt switch and the load, the crowbar circuit configured to provide a crowbar low resistance path for directing leakage current from the positive side electrical power control away from the load when the electrical protective device enters the standby mode.

7. An electrical protective device configured to mitigate leakage current in an electrical circuit, the electrical protective device comprising:
an electrical power control electrically connected to a line side of the electrical circuit and configured to control electrical power from a power source electrically connected to the electrical circuit, wherein the electrical power control is electrically connected in series with a load electrically connected to the electrical circuit; and
a crowbar circuit electrically connected to the electrical circuit in series with the electrical power control and in parallel with the load, the crowbar circuit configured to provide a crowbar low resistance path for directing leakage current from the electrical power control away from the load when the electrical protective device enters a standby mode in which the electrical power control is at least partially turned off.

8. The electrical protective device of claim 7, further comprising a shunt switch electrically connected to the electrical circuit in series with the electrical power control and in parallel with the crowbar circuit and the load, the shunt switch configured to provide a shunt low resistance path for directing leakage current from the electrical power control away from the load when the electrical protective device enters the standby mode.

9. The electrical protective device of claim 8, wherein at least one of the crowbar circuit and shunt switch are configured to turn off when the electrical protective device enters an on mode, and wherein the electrical power control is configured to turn on after at least one of the crowbar circuit and shunt switch are turned off.

10. The electrical protective device of claim 8 or 9, further comprising a voltage sensor electrically connected to the electrical circuit, the voltage sensor configured to measure voltage on the line side of the electrical circuit and on a load side of the electrical circuit to determine when to use at least one of the crowbar circuit and the shunt switch to direct leakage current from the electrical power control away from the load.

11. The electrical protective device of claim 10, wherein the crowbar circuit is turned off and the shunt switch is turned on when the voltage measured by the voltage sensor is below a predetermined threshold, or
wherein the crowbar circuit is turned on and the shunt switch is turned on when the voltage measured by the voltage sensor meets or exceeds a predetermined threshold.

12. The electrical protective device of claim 10 or 11, wherein the voltage measured by the voltage sensor comprises a first voltage of the electrical circuit before the crowbar circuit is used and wherein the voltage sensor is further configured to measure a second voltage of the electrical circuit after the crowbar circuit is used to enable the electrical protective device to use the shunt switch if the second voltage meets or exceeds a predetermined threshold.

13. An electrical protective device configured to mitigate leakage current in an electrical circuit, the electrical protective device comprising:
a positive side electrical power control electrically connected to a line side of the electrical circuit and configured to control electrical power from a power source electrically connected to the electrical circuit, wherein the positive side electrical power control is electrically connected in series with a load electrically connected to the electrical circuit;
a negative side electrical power control electrically connected to the line side of the electrical circuit and configured to control electrical power from the power source electrically connected to the electrical circuit, wherein the negative side electrical power control is electrically connected in series with the load; and
a common mode voltage protection system electrically connected to the electrical circuit between the positive side electrical power control and the negative side electrical power control and in parallel with the load, the common mode voltage protection system configured to provide a low resistance path for directing leakage current from at least one of the positive side electrical power control and negative side electrical power control, away from the load when the electrical protective device enters a standby mode in which the negative side and positive side electrical power controls are at least partially turned off.

14. The electrical protective device of claim 13, wherein the common mode voltage protection system comprises a first shunt switch, a ground, and a second shunt switch, the first shunt switch electrically connected in series between the positive side electrical power control and the ground, the second shunt switch electrically connected in series between the negative side electrical power control and the ground.

15. The electrical protective device of any one of the preceding claims, wherein the shunt switch comprises a mechanical shunt switch or an electronic shunt switch.
